# EUROPÄISCHE PATENTANMELDUNG

(11) **EP 1 881 332 A2**
(43) Veröffentlichungstag der Anmeldung: **23.01.2008**
(21) Anmeldenummer: 07111264.3
(22) Anmeldetag: 28.06.2007
(51) Int. Cl.: G01R 31/28, G03F 7/20, H01L 21/66, H01L 21/68, H01L 21/683, H01L 21/687, H01L 41/09

(54) **Positioniereinheit für optische und/oder elektrische Prüfsysteme**

(30) Priorität: 03.07.2006 DE 102006030589
(71) Anmelder: Siemens Aktiengesellschaft, 80333 Munich (DE)
(72) Erfinder: Gerhard, Detlef, 81829, München (DE); Lechner, Johannes, 80798, München (DE)

(57) **Zusammenfassung**

Positioniereinheit (1) zur kurzzeitigen dreidimensionalen Positionierung von auf einem Chuck (G) geladenen Werkstücken relativ zu einem optischen oder elektrischen Testsystem, welche Folgendes aufweist:
- eine z-Antriebseinheit (A) zur Grobpositionierung des Chucks (G),
- eine y-Antriebseinheit (B),
- eine X-Antriebseinheit (C),
- eine Rotationsantriebseinheit (D),
- eine Z'-Antriebseinheit (E) zur Feinpositionierung des Chucks (G),

wobei eine Hebevorrichtung für ein auf dem Chuck (G) positioniertes Werkstück separat vom Chuck dargestellt ist, mehrere nach oben und parallel zur z-Achse gerichtete Stifte (2) aufweist, die mit Durchgangsöffnungen im Chuck zusammenwirken.

Anwendungsgebiete: Testgeräte für insbesondere Flachbaugruppen, Nano-Technologie

## Beschreibung

Die Erfindung betrifft dreidimensional verfahrbare Werkstückträger, insbesondere für Baugruppen, Chips auf Wafern oder ähnlichem. Betrachtet werden insbesondere die Positionierung und dabei die Optimierung der Bewegung der zu behandelnden Teile.

Zum elektrischen Testen von Baugruppen, Chips auf Wafern oder sonstiger Komponenten wird das zu testende Objekt an die Messnadelspitzen eines Messinstruments herangefahren, mit den Messspitzen kontaktiert und in der Folge vermessen.

Eine Anwendungsmöglichkeit der hier behandelten Positioniersysteme ist der Einsatz beim Testen von Wafern, die eine Vielzahl von Chips enthalten, von denen jeder einzeln zu testen ist. Hierbei wird ein Wafer meist vollständig getestet, wobei auch stichprobenweise Testreihen durchgeführt werden können. Zum Prüfen wird ein Los von Wafern bereitgestellt. Aus diesem heraus wird ein Wafer auf einen so genannten Chuck (Träger) des Testsystems geladen und der elektrische beziehungsweise der Funktionstest werden durchgeführt. Während des Testablaufs wird ein Chip oder es werden mehrere Chips des Wafers unter die Messnadelkarte, die die Messnadeln enthält, gefahren. Der Wafer wird insoweit angehoben, dass die Messnadeln die betreffenden Chips kontaktieren und der Test wird gestartet. Anschließend wird der Wafer abgesenkt und es werden die nächsten Chips relativ zu den Messkontakten positioniert und durch Anheben des Wafers kontaktiert.

Das Positionieren und Anheben des Wafers sollte idealer Weise in minimaler Zeit erfolgen. Systeme nach dem Stand der Technik benötigen für derartige Positionierungen und Kontaktierungen minimal 100 ms. Mit jeder neuen Prüfgerätegeneration ist die Bestrebung verbunden, die Zeiten weiter zu verkürzen.

Trotzdem ist der Positioniervorgang so zu gestalten, dass die Beschädigungen an Nadelkarte, Messkontakt und an den Abgreifstellen an einem Chip minimal bleiben.

Bei Systemen nach dem Stand der Technik basiert eine Positionierung auf der Verwendung von steuerbaren Antrieben in x-, y- und z-Richtung, wobei die x-y-Ebene der Bewegung möglichst parallel zu einer Waferfläche ist. Die z-Richtung zeigt nach oben und steht damit senkrecht auf der x-y-Ebene und auf dem Wafer. Zusätzlich besitzen die Testgeräte eine Rotationseinheit, mit der der Wafer um die z-Achse gedreht werden kann.

Zum Erreichen hoher Positionierungsgeschwindigkeiten werden oft zwei z-Antriebe verwendet. Ein z-Antrieb für eine grobe Bewegung und ein z-Antrieb für eine feine schnelle Bewegung. Beide z-Antriebe sind auf beziehungsweise oberhalb der x-y-Ebene beziehungsweise auf den entsprechenden Antrieben gelagert. Der z-Antrieb für die schnelle Bewegung basiert hierbei beispielsweise auf einer Kurvenscheibe, die minimale Hübe ausführt und schnell bewegt werden kann. Mittels dieser Antriebe wird der Chuck bewegt. Der Chuck selbst besteht aus einer Fläche zum Auflegen des Wafers. Innerhalb der Auflagefläche sind Vakuumbohrungen zur Ansaugung des Wafers vorhanden. Weiterhin sind in der Fläche versenkbare Stifte vorgesehen, mittels der ein Anheben und Absenken des Wafers durchführbar ist. Nachteile dieser Vorrichtungen bestehen insbesondere hinsichtlich der notwendigen Bewegung von großen Massen, was entsprechende Antriebskräfte erfordert.

Der Erfindung liegt die Aufgabe zugrunde, ein Positioniersystem bereitzustellen, mit dem schnelle und genaue Positionierungen von auf Chucks geladenen Werkstücken an Testadapter heranzufahren und zur Bearbeitung zu halten. Die Lösung dieser Aufgabe geschieht durch die Merkmalskombination entsprechend Anspruch 1.

Vorteilhafte Ausgestaltungen sind den Unteransprüchen zu entnehmen.

Der Erfindung liegt die Erkenntnis zugrunde, dass mit einem neuen Bewegungskonzept für den Aufbau und die Bewegung einer Positioniereinheit die gewünschten Weiterentwicklungen realisierbar sind.
Hierzu werden im Wesentlichen bekannte Antriebseinheiten für übliche dreidimensional positionierbare Einheiten verwandt. Die Realisierung der Beschleunigung bestimmter Lade- und Transportvorgänge wird dadurch erreicht, dass oberhalb der Antriebe, beispielsweise für die x- und y-Achse die für die Positionierung während eines Testvorganges im Wesentlichen bewegten Einheiten oder Anteile in der Masse drastisch reduziert werden. Dies gilt insbesondere für den Chuck. Der Aufbau der Positioniereinheit beinhaltet damit von unten nach oben betrachtet zunächst einen Z-Antrieb (A) gefolgt von einer Y-Antriebseinheit (B) und einer X-Antriebseinheit (C). Im Anschluss daran ist eine Rotationsantriebseinheit (D) vorgesehen und eine Z'-Antriebseinheit (E) zur Feinpositionierung des Chucks (G). Damit befindet sich die Z-Antriebsachse (A) für die Grobpositionierung unterhalb der x-y-Einheiten, die allgemein als Tisch bezeichnet wird. Der Chuck, der beispielsweise einen zu testenden beispielsweise einen bestückten Wafer aufnimmt, ist somit das oberste Bestandteil der Positioniereinheit und kann den Wafer relativ zu einem Testsystem transportieren, zum eigentlichen Test positionieren und mit hoher Geschwindigkeit weiter verfahren.

Das neue Konzept einer Positioniereinheit mit einer entsprechend hohen Positionierfrequenz, beispielsweise im Bereich von 100 ms weist zwar den Nachteil auf, dass der untere Z-Antrieb das gesamte Bewegungssystem bewegen muss. Das neue Konzept ist jedoch damit verbunden, dass ein wesentlicher Vorteil erzielbar ist, indem die während eines Tests und der damit verbundenen Werkstückpositionierung zu bewegenden Antriebe minimale Lasten zu transportieren haben.

Es ist besonders vorteilhaft, wenn der Chuck (G) selbst keine Aushebevorrichtung für einen Wafer aufweist, was mit einer wesentlichen Gewichtsreduzierung verbunden ist. Die Hebevorrichtung ist dafür an einer Position anfahrbar, an welche der auf dem Chuck vorhandene Wafer von diesen entnommen werden soll. Durch gegenseitige Bewegungen zwischen Hebevorrichtung und Chuck kann der Wafer vom Chuck abgehoben werden.

Wenn die Z'-Antriebseinheit (E) mit einem piezoelektrischen Aktor verstehen ist, lassen sich entsprechende Hübe mit hoher Frequenz ausführen. Um das Gewicht für die zu beschleunigenden Massen weiterhin zu reduzieren, ist es vorteilhaft, den Chuck in Wabenform herzustellen. Dies bietet die Möglichkeit einer mechanisch stabilen Konstruktion mit gleichzeitig reduzierter Masse.

Es ist weiterhin vorteilhaft, den Chuck (G) mit senkrechten Durchgangsbohrungen auszustatten, die mit einer extern platzierten Hebevorrichtung (F) zusammenwirken, in dem Sinn, dass Stifte der Hebevorrichtung in Durchgangsbohrungen innerhalb des Chucks eingeführt und durchgeführt werden.

Im Folgenden wird anhand der schematischen Figur ein Ausführungsbeispiel beschrieben.

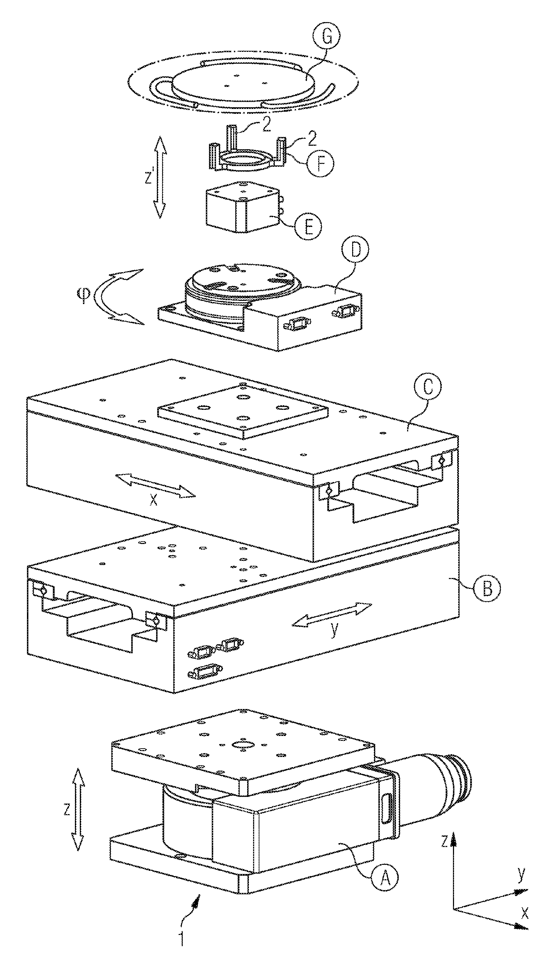

Die Figur zeigt entsprechend dem neuen Bewegungskonzept ein Positioniersystem, beziehungsweise eine Positioniereinheit zur Beschleunigung der Positionierung eines Chucks.

Die Minimierung der Massen oberhalb der x-, y-Antriebe, die bei der Positionierung während des Test/der Prüfung auch verwendet werden, sowie eine drastisch reduzierte Masse für den Chuck tragen zur Erreichung der gestellten Anforderungen bei.

Der Aufbau der Antriebe von unten nach oben ist wie folgt: Grober Z-Antrieb gefolgt von den X- und Y-Antriebseinheiten, auf denen wiederum ein Rotationsantrieb sitzt. Für die Feinpositionierung des Chucks wird ein so genannter Piezo-Antrieb verwendet. Dieser Aufbau weist wie gesagt den Nachteil auf, dass der untere Z-Antrieb das gesamte Bewegungssystem tragen muss, wobei sich jedoch durch diese Aufteilung der Bewegungseinheiten die für die Antriebe in z-Richtung verantwortlich sind, der große Vorteil ergibt, dass die während des Tests eines Chips, der auf einem Wafer auf einem Chuck positioniert ist, die hierfür notwendige Waferpositionierung mit entsprechenden Positionsveränderungen durch Bewegung reduzierter Massen, die sich oberhalb des x-y-Tisches befinden, bewerkstelligt wird.

Der obere z'-Antrieb ist ein Piezomotor mit dem der Chuck schnell und genau gehoben werden kann. Der Chuck besitzt keine Aushebevorrichtung für einen auf ihm liegenden Wafer. Der Chuck weist lediglich durchgehende Löcher auf, die unterhalb eines Aufliegenden Wafers positioniert sind und durch die Stifte einer externen Hebevorrichtung zum Abheben des Wafers vom Chuck durchführbar sind. Somit existiert eine Zone innerhalb des Chucks, die unterhalb des Wafers positioniert ist und an der die externe Hebevorrichtung F mit entsprechenden Stiften 2 einfahrbar ist, um einen Wafer abzuheben.

Der gesamte Vorgang wird durch Relativpositionen von Wafer und Hebevorrichtung erreicht.

Zum Ausheben des Wafers wird der Chuck in eine definierte Transferstellung gefahren, so dass die Stifte der außerhalb des Chucks positionierten Aushebevorrichtung den Wafer anheben können.

Zur Gewichtsreduzierung besitzt der innere Aufbau des Chucks G eine Wabenform aus dicht nebeneinander liegenden Hohlräumen mit entsprechend geringer Masse. Zur schnellen Positionierung des Chucks in z-Richtung wird nur der obere Piezoantrieb, der z'-Antrieb E zur Feinpositionierung verwendet. Dieser Antrieb wird beispielsweise als Piezoantrieb ausgelegt und über einen programmierbaren Wellenformgenerator angesteuert. So lässt sich das Beschleunigungsverhalten der Bewegung des Chucks optimieren. Vorteile ergeben sich insbesondere durch minimale Stöße beziehungsweise minimales Klirren beim Anschlagen der Waferoberfläche an die Messnadeln.

Die Vorteile der oben beschriebenen Positioniereinheit liegen in der stark reduzierten Masse des Chucks und somit in der Möglichkeit, einen Piezoantrieb zu verwenden. Mit diesem Aufbau können Positioniergeschwindigkeiten erreicht werden, die einen Wafer beziehungsweise einen Chip von einer zur nächsten Position innerhalb von 30 ms versetzen. In der Darstellung entsprechend der beiliegenden Figur ist der Bewegungsaufbau angedeutet. Eine so genannte Messkarte mit den Messnadeln ist oberhalb des Chucks G positioniert, jedoch nicht Bestandteil des Bewegungssystems.

## Patentansprüche

1. Positioniereinheit (1) zur kurzzeitigen dreidimensionalen Positionierung von auf einem Chuck (G) geladenen Werkstücken relativ zu einem optischen oder elektrischen Testsystem, welche Folgendes aufweist:
- eine z-Antriebseinheit (A) zur Grobpositionierung des Chucks (G),
- eine y-Antriebseinheit (B),
- eine X-Antriebseinheit (C),
- eine Rotationsantriebseinheit (D),
- eine Z'-Antriebseinheit (E) zur Feinpositionierung des Chucks (G),
wobei eine Hebevorrichtung für ein auf dem Chuck (G) positioniertes Werkstück separat vom Chuck dargestellt ist, mehrere nach oben und parallel zur z-Achse gerichtete Stifte (2) aufweist, die mit Durchgangsöffnungen im Chuck zusammenwirken.

2. Positioniereinheit nach Anspruch 1, bei denen die Z'-Antriebseinheit (E) zur Feinpositionierung des Chucks (G) einen piezoelektrischen Aktor aufweist.

3. Positioniereinheit nach Anspruch 1 oder 2, bei der der Chuck (G) eine Wabenform zur Reduzierung der Masse aufweist.

4. Positioniereinheit nach Anspruch 3, bei der Hohlräume im Chuck (G) senkrechte Durchgänge bilden.
